# EUROPEAN PATENT SPECIFICATION

(11) **EP 3 928 976 B1**
(45) Date of publication and mention of the grant of the patent: **28.02.2024**
(21) Application number: 20758676.9
(22) Date of filing: 14.02.2020
(51) Int. Cl.: C08J 7/04, C09D 129/04, B32B 7/022, C08K 3/36, C09D 5/00, C09D 7/61

(54) **GAS BARRIER LAMINATE**
GASBARRIERELAMINAT
STRATIFIÉ FORMANT BARRIÈRE CONTRE LES GAZ

(30) Priority: 21.02.2019 JP 2019029822
(43) Date of publication of application: 29.12.2021
(73) Proprietor: SUMITOMO CHEMICAL COMPANY, LIMITED, Chuo-ku Tokyo 104-8260 (JP)
(72) Inventor: SHIBATA, Daisuke, Osaka-shi, Osaka 554-8558 (JP)
(74) Representative: Winter, Brandl - Partnerschaft mbB
(86) International application number: PCT/JP2020/005763
(87) International publication number: WO 2020/170958

(56) References cited:
- EP-A1- 1 428 657
- WO-A1-2014/050951
- WO-A1-2019/107321
- JP-A- 2005 088 197
- JP-A- 2008 230 153
- JP-A- 2009 095 765
- JP-A- 2015 036 208
- JP-A- 2018 001 631
- JP-A- 2018 192 693
- DATABASE WPI Week 199948 1996 Thomson Scientific, London, GB; AN 1999-566686 XP002807770, & JP H11 246729 A (SUMITOMO CHEM CO LTD) 14 September 1999 (1999-09-14)

## Description

### Technical Field

The present invention relates to a gas barrier laminate.

### Background Art

A packaging material for foods, medicines, and the like is often required to have performance for preventing transmission of gas such as oxygen and water vapor (gas barrier properties) in order to suppress deterioration of its content. Various techniques have been proposed in order to achieve excellent gas barrier properties.

For example, Patent Literature 1 discloses a gas barrier laminate having a laminated structure comprising a base material, a vapor deposition layer consisting of an inorganic compound (first layer), and a barrier layer formed from a coating agent (second layer) in this order (claim 1 and the like). In Example 1 in this Patent Literature 1, a coating agent obtained by mixing a solution of hydrolyzed tetraethoxysilane and a solution of polyvinyl alcohol is applied onto a laminate having a laminated structure of a base material formed from polyethylene terephthalate/a vapor deposition layer formed from a silicon oxide (first layer) and the resultant is then dried to produce a gas barrier laminate.

Patent literature 2 discloses a gas-barrier laminate comprising a base material, an inorganic layer and a gas-barrier layer comprising polyvinyl alcohol and a condensate of hydrolyzed metal oxide.

### Citation List

### Patent Literature

Patent Literature 1: Japanese Patent Laid-Open No. 7-164591 Patent Literature 2: Japanese Patent Application JP 2018 001631 A

### Summary of Invention

### Technical Problem

In the field of packaging materials for foods, medicines, and the like, an enhancement in gas barrier properties has always been required. The present invention has been made focusing on such circumstances, and an object thereof is to provide a gas barrier laminate excellent in gas barrier properties.

### Solution to Problem

The present invention capable of achieving the above object is defined in the claims.

### Advantageous Effect of Invention

According to the present invention, a gas barrier laminate excellent in gas barrier properties can be obtained.

### Description of Embodiments

Hereinafter, the present invention will be described in order. Note that the examples, preferable aspects, and the like described herein can be combined as long as they do not contradict each other.

The present invention relates to a gas barrier laminate having a laminated structure comprising a barrier layer, an inorganic material layer and a base material in this order. The gas barrier laminate may comprise a barrier layer, an inorganic material layer and a base material in this order, and other layers can exist between each layer. Examples of the other layers include an adhesive layer and a primer layer.

Examples of the laminated structure include "barrier layer/inorganic material layer/base material", "barrier layer/inorganic material layer/primer layer/base material", "barrier layer/primer layer/inorganic material layer/base material", "barrier layer/primer layer/inorganic material layer/primer layer/base material", and "barrier layer/inorganic material layer/first base material/adhesive layer/second base material". In the aspect, the layer and the base material may each have a single layer or two or more layers. Note that the expression "barrier layer/inorganic material layer" herein indicates a state where the barrier layer and the inorganic material layer are directly in contact with each other. Other expressions have also the same meaning.

The laminated structure is preferably formed from only a barrier layer, an inorganic material layer and a base material. That is, it is preferable that the gas barrier laminate consists of a barrier layer, an inorganic material layer and a base material and has a laminated structure in which the barrier layer, the inorganic material layer and the base material are laminated in this order (that is, "barrier layer/inorganic material layer/base material"). In this aspect, the barrier layer, the inorganic material layer and the base material may all have two or more layers, but more preferably each of them has a single layer.

One of the characteristics of the present invention is that the barrier layer includes a water-soluble resin and a condensate of hydrolyzed metal alkoxide.

As water-soluble resin, only one type thereof may be used, or two or more types thereof may be used in combination. Examples of the water-soluble resin include polyvinyl alcohol, polyvinylpyrrolidone, starch, methylcellulose, carboxymethylcellulose, and sodium alginate. Among those, polyvinyl alcohol is preferable from the viewpoint of gas barrier properties.

The weight average molecular weight of the water-soluble resin is preferably from 10,000 to 100,000, more preferably from 12,000 to 90,000, further preferably from 14,000 to 80,000 from the viewpoints of gas barrier properties, flexibility and film-forming properties. This weight average molecular weight can be measured by gel permeation chromatography (GPC).

When polyvinyl alcohol is used as a water-soluble resin, the average polymerization degree thereof is preferably from 100 to 3,000, more preferably from 200 to 2,500, and further preferably from 400 to 2,000 from the viewpoints of gas barrier properties and flexibility. The average polymerization degree of polyvinyl alcohol can be calculated from a relative viscosity with water, the relative viscosity with water being obtained using a viscometer.

When polyvinyl alcohol is used as a water-soluble resin, the saponification degree thereof is preferably from 90 to 100 mol%, more preferably from 95 to 100 mol%, and further preferably from 98 to 100 mol% from the viewpoint of gas barrier properties. The saponification degree of polyvinyl alcohol can be obtained by determining an amount of a residual acetic group in a sample using sodium hydroxide.

The content of the water-soluble resin in the barrier layer is preferably from 10 to 90% by weight, more preferably from 15 to 65% by weight, and further preferably from 20 to 60% by weight based on the entire barrier layer from the viewpoints of gas barrier properties and flexibility. Note that, when two or more water-soluble resins are used, the above-described content is a total content of the two or more water-soluble resins.

As condensate of hydrolyzed metal alkoxide, only one type thereof may be used, or two or more types thereof may be used in combination. Here, in the present invention, the term "metal" of the "metal alkoxide" includes not only common metals, but also semimetals. Examples of the metals of the metal alkoxide include Si, Al, Ti, and Zr.

The condensate of hydrolyzed metal alkoxide is preferably a condensate of hydrolyzed tetraethoxysilane and/or a condensate of hydrolyzed triisopropoxy aluminum and more preferably a condensate of hydrolyzed tetraethoxysilane.

The solid content of a metal oxide in the barrier layer, which is converted from an amount of a metal alkoxide, is preferably from 10 to 400 parts by weight, more preferably from 50 to 350 parts by weight, and further preferably from 70 to 300 parts by weight based on 100 parts by weight of the content of the water-soluble resin from the viewpoint of gas barrier properties. Here, when the condensate of hydrolyzed metal alkoxide is, for example, a condensate of hydrolyzed tetraethoxysilane, the above-described "solid content of a metal oxide in the barrier layer, which is converted from an amount of a metal alkoxide" means a "solid content of SiO₂ in the barrier layer, which is converted from an amount of tetraethoxysilane". The same applies to another condensate of hydrolyzed metal alkoxide.

In addition, when the condensate of hydrolyzed metal alkoxide is, for example, a condensate of hydrolyzed tetraethoxysilane and a condensate of hydrolyzed triisopropoxy aluminum, the above-described "solid content of a metal oxide in the barrier layer, which is converted from an amount of a metal alkoxide" means a "total of a solid content of SiO₂ in the barrier layer, which is converted from an amount of tetraethoxysilane and a solid content of Al₂O₃ in the barrier layer, which is converted from a content of triisopropoxy aluminum". The same also applies to a case where the condensates of two or more other hydrolyzed metal alkoxides exist in the barrier layer.

The barrier layer may include other components different from the water-soluble resin and the condensate of hydrolyzed metal alkoxide described above. Examples of other components include components (example: a solvent, a metal alkoxide and/or a hydrolysate thereof) included in a coating agent which is used for forming the barrier layer. The content of other components in the barrier layer is preferably from 0 to 50% by weight, more preferably from 0 to 30% by weight, and further preferably from 0 to 20% by weight based on the entire barrier layer from the viewpoint of gas barrier properties. Note that, when two or more other components exist in the barrier layer, the above-described content corresponds to a total content of the two or more other components.

One of the characteristics of the present invention is that the frictional force of the barrier layer measured by atomic force microscopy is 3.0 × 10⁻⁴ (V) or less. Such a low frictional force of the barrier layer is assumed to be obtained since the water-soluble resin and the condensate of hydrolyzed metal alkoxide are uniformly dispersed in the barrier layer. The gas barrier laminate of the present invention including the barrier layer having a low frictional force, which is assumed to be caused by such uniform dispersion, allows excellent gas barrier properties to be achieved. However, the present invention is not limited to such an assumption.

The frictional force is preferably 2.8 × 10⁻⁴ (V) or less and more preferably 2.6 × 10⁻⁴ (V) or less. This frictional force is a value measured and calculated by a method described in Example section described later.

The thickness of the barrier layer is preferably from 0.01 to 5.0 µm, more preferably from 0.05 to 2.0 µm, and further preferably from 0.1 to 1.0 µm from the viewpoints of gas barrier properties and flexibility. Note that, when two or more of the barrier layers exist, the above-described thickness corresponds to a total thickness of the barrier layers. The thickness of the undried coating film may be set as appropriate so that the thickness provides a desired thickness of the barrier layer.

As inorganic material forming the inorganic material layer, only one type thereof may be used, or two or more types thereof may be used in combination. Examples of the inorganic materials include a metal and an inorganic oxide. As metal, only one type thereof may be used, or two or more types thereof may be used in combination. The metal is preferably aluminum. As inorganic oxide, only one type thereof may be used, or two or more types thereof may be used in combination. Examples of the inorganic oxides include aluminum oxide, silicon oxide, and magnesium oxide. The inorganic oxide is preferably aluminum oxide due to low cost. The inorganic material layer is preferably a layer which is formed by vapor deposition.

The inorganic material forming the inorganic material layer is preferably an inorganic oxide, more preferably at least one selected from the group consisting of aluminum oxide, silicon oxide, and magnesium oxide, and further preferably aluminum oxide.

The thickness of the inorganic material layer is preferably from 1 to 200 nm, more preferably from 2 to 150 nm, and further preferably from 3 to 100 nm from the viewpoints of gas barrier properties and flexibility. Note that, when two or more of the inorganic material layers exist, the above-described thickness corresponds to a thickness of each inorganic material layer.

As base material, only one type thereof may be used, or two or more types thereof may be used in combination. Examples of the base materials include polyesters such as polyethylene terephthalate and polyethylene naphthalate, polyolefins such as polyethylene and polypropylene, polystyrene, polyamide, polyvinyl chloride, polycarbonate, polyacrylonitrile, and polyimide. The base material is preferably polyester and more preferably polyethylene terephthalate.

The thickness of the base material is preferably from 5 to 50 µm, more preferably from 7 to 40 µm, and further preferably from 9 to 30 µm from the viewpoint of productivity of the gas barrier laminate. Note that, when two or more of base materials exist, the above-described thickness corresponds to a thickness of each base material.

The gas barrier laminate in which the frictional force of the barrier layer measured by atomic force microscopy is 3.0 × 10⁻⁴ (V) or less can be produced by (1) producing a mixture including a water-soluble resin, a metal alkoxide and/or a hydrolysate thereof, and a solvent, (2) subjecting the obtained mixture to a high-pressure dispersion process for uniformly dispersing the components therein to produce a coating agent, and (3) applying the obtained coating agent onto a laminate having a laminated structure comprising an inorganic material layer and a base material in this order and then drying the resultant. It is preferable that the high-pressure dispersion process is carried out by applying a high pressure to the mixture and passing the mixture through a thin tube formed in a chamber of a high-pressure dispersion apparatus at a high speed.

In Examples 1 and 2 described later, where the high-pressure dispersion process was carried out, a gas barrier laminate which not only allowed the requirements for the frictional force to be satisfied, but also was excellent in gas barrier properties could be produced. However, in Comparative Example 1 described later, where the high-pressure dispersion process was not carried out, such a gas barrier laminate could not be produced. From these results, a low frictional force of the barrier layer and excellent gas barrier properties thereby are assumed to be obtained since the water-soluble resin and the condensate of hydrolyzed metal alkoxide are uniformly dispersed in the barrier layer as described above. Note that, Patent Literature 1 does not disclose nor suggest the characteristic of the present invention that the frictional force of the barrier layer is low and a means (for example, high-pressure dispersion) for realizing the same. In addition, Patent Literature 1 discloses in Example 1, that a coating agent produced by simply mixing a solution of hydrolyzed tetraethoxysilane and the like was used, and Example 1 corresponds to Comparative Example 1 in the present application described later.

A commercially available product can be used as a high-pressure dispersion apparatus. Examples of the commercially available products include "Ultra High Pressure Homogenizer M110E/H" manufactured by Microfluidics international Corporation, "Star Burst" manufactured by SUGINO MACHINE LIMITED, and "Homogenizer" manufactured by SANWA ENGINEERING CO., LTD. The pressure upon high-pressure dispersion process is preferably from 10 to 2,500 kgf/cm² and more preferably from 100 to 2,000 kgf/cm². The temperature upon high-pressure dispersion process is preferably from 5 to 50°C and more preferably from 7 to 45°C. The diameter of the thin tube through which the mixture passes is preferably from 10 to 500 µm and more preferably from 50 to 400 µm. The number of times of the high-pressure dispersion process is preferably 1 or 2.

The content of the water-soluble resin in the coating agent is preferably from 0.1 to 10% by weight, more preferably from 0.2 to 5% by weight, and further preferably from 0.3 to 3% by weight based on the entire coating agent from the viewpoint of gas barrier properties. Note that, when two or more water-soluble resins are used, the above-described content corresponds to a total content of the two or more water-soluble resins. The other descriptions about the water-soluble resin are the same as described above.

As metal alkoxide in the coating agent, only one type thereof may be used, or two or more types thereof may be used in combination. In addition, as hydrolyzed metal alkoxide, only one type thereof may be used, or two or more types thereof may be used in combination. The metal alkoxide and/or the hydrolysate thereof is preferably at least one selected from the group consisting of tetraethoxysilane, hydrolyzed tetraethoxysilane, triisopropoxy aluminum, and hydrolyzed triisopropoxy aluminum, more preferably tetraethoxysilane and/or hydrolyzed tetraethoxysilane, and further preferably hydrolyzed tetraethoxysilane.

It is preferable that the content of the metal alkoxide and/or the hydrolysate thereof in the coating agent is set as appropriate so that the above-described "solid content of a metal oxide in the barrier layer, which is converted from an amount of a metal alkoxide" is included in the preferable range described above.

As solvent, only one type thereof may be used, or two or more types thereof may be used in combination. Examples of the solvents include water; alcohol solvents such as methanol, ethanol, and isopropyl alcohol; ester solvents such as ethyl acetate and butyl acetate; and ketone solvents such as methyl ethyl ketone. The solvent is preferably a mixed solvent of water and an organic solvent, more preferably a mixed solvent of water and an alcohol solvent, and further preferably a mixed solvent of water and isopropyl alcohol.

The content of the solvent in the coating agent is preferably from 80 to 99.8% by weight, more preferably from 90 to 99.6% by weight, and further preferably from 94 to 99.4% by weight based on the entire coating agent in order to uniformly maintain the water-soluble resin and the metal alkoxide and/or the hydrolysate thereof in the coating agent. Note that, when two or more solvents are used, the above-described content corresponds to a total content of the two or more solvents.

When a mixed solvent of water and an organic solvent (more preferably an alcohol solvent and further preferably isopropyl alcohol) is used as a solvent, the amount of the organic solvent (more preferably an alcohol solvent and further preferably isopropyl alcohol) in the mixed solvent is preferably from 1 to 100 parts by weight, more preferably from 5 to 80 parts by weight, further preferably from 10 to 70 parts by weight relative to 100 parts by weight of water in order to uniformly maintain the water-soluble resin and the metal alkoxide and/or the hydrolysate thereof in the coating agent. Note that, when two or more organic solvents are used, the above-described amount corresponds to a total amount of the two or more organic solvents.

The descriptions about the inorganic material layer and the base material in the laminate to which the coating agent is applied, are the same as described above. The laminate to which the coating agent is applied may comprise the inorganic material layer and the base material in this order and, for example, other layers may exist between the inorganic material layer and the base material or on the inorganic material layer. Examples of the other layers include an adhesive layer and a primer layer.

Examples of the laminated structures of the laminate to which a coating agent is applied include "inorganic material layer/base material", "inorganic material layer/primer layer/base material", "primer layer/inorganic material layer/base material", "primer layer/inorganic material layer/primer layer/base material", and "inorganic material layer/first base material/adhesive layer/second base material". In the aspect, the layer and the base material may each have a single layer or two or more layers.

A method for applying the coating agent may be a batch type method or may be a continuous type method. Examples of the applying method include gravure methods such as a direct gravure method and a reverse gravure method; a roll coating methods such as a two-roll beat coating method and a bottom feed three reverse coating method; a doctor knife method; a die coating method; a bar coating method; a dipping method; a spray coating method; a curtain coating method; a spin coating method; a flexo coating method; a screen coating method; and a method using brush or writing brush.

Drying of a coating film formed by applying the coating agent is preferably carried out by heating to form the condensate of hydrolyzed metal alkoxide in the barrier layer. Heating can be carried out using a drying furnace or a heater. The drying temperature is preferably from 50 to 150°C, more preferably from 60 to 150°C, and further preferably from 70 to 140°C, and the drying time is preferably from 0.1 to 120 seconds, more preferably from 0.2 to 100 seconds, and further preferably from 0.5 to 70 seconds from the viewpoints of removal of the solvent and progress of a condensation reaction of the metal alkoxide and/or the hydrolysate thereof. Drying is preferably carried out in an air atmosphere under normal pressure.

The gas barrier laminate of the present invention is excellent in gas barrier properties, therefore using this gas barrier laminate for a packaging material for foods, medicines, and the like, allows their deterioration to be suppressed and their storage periods to be extended. As a result, the amount of waste of foods, medicines, and the like can be reduced, therefore the gas barrier laminate of the present invention can contribute to resource-saving.

### Examples

Hereinafter, the present invention will be described in further detail with reference to Examples, but the present invention is not limited to the following Examples. Any modifications can be suitably made within the scope which can comply with the purpose described above and below to carry out the present invention and all modifications are included in the technical scope of the present invention.

### Production of gas barrier laminate

### Example 1

### (1) Production of coating agent

10.4 g of tetraethoxysilane and 89.6 g of 0.1 N hydrochloric acid were mixed, and the obtained mixture was stirred for 30 minutes for hydrolyzing tetraethoxysilane to prepare Solution A having 3% by wight of a solid content of SiO₂ which is converted from the content of tetraethoxysilane (hereinafter, abbreviated as "SiO₂ solid content").

10.0 g of polyvinyl alcohol ("PVA-105" manufactured by KURARAY CO., LTD., average polymerization degree: 500, saponification degree: 98 to 99 mol%), 290.8 g of water, and 32.3 g of isopropyl alcohol were mixed to prepare Solution B.

Solution A and Solution B were mixed so that the weight ratio of Solution A to Solution B was 2:3, and the obtained mixture was subjected to a high-pressure dispersion process once under the conditions of a temperature of 30°C and a pressure of 1,250 kgf/cm² using a high-pressure dispersion apparatus ("Ultra High Pressure Homogenizer M110-E/H" manufactured by Microfluidics international Corporation, diameter of the thin tube: 100 µm) to obtain a coating agent. Note that the content and the solid content of each component relative to the entire coating agent prepared are described below: the content of polyvinyl alcohol was 1.2% by weight, the solid content of SiO₂ was 1.8% by weight, the content of water was 87.3% by weight, and the content of isopropyl alcohol was 9.7% by weight. In addition, the amount of isopropyl alcohol was 11.1 parts by weight relative to 100 parts by weight of water.

### (2) Production of gas barrier laminate

The obtained coating agent was applied onto the inorganic material layer of an aluminum oxide vapor deposition film ("BARRIALOX 1011HG" manufactured by TORAY ADVANCED FILM CO., LTD., base material: polyethylene terephthalate (PET), thickness of the base material: 12 µm, inorganic material layer: aluminum oxide layer, thickness of the inorganic material layer: 5 to 7.5 nm) with a bar coater and the resultant was dried at 120°C in a hot air oven for 1 minute to produce a gas barrier laminate having a laminated structure of the barrier layer/the inorganic material layer/the base material (thickness of the barrier layer: 0.3 µm). Note that drying was carried out in an air atmosphere under normal pressure.

The content of polyvinyl alcohol in the barrier layer was 40% by weight based on the entire barrier layer, and the solid content of SiO₂ in the barrier layer, which is converted from an amount of tetraethoxysilane, was 150 parts by weight based on 100 parts by weight of the content of polyvinyl alcohol.

### Example 2

A coating agent was produced in the same manner as in Example 1 except that the high-pressure dispersion process was carried out twice. The obtained coating agent was applied onto the aluminum oxide vapor deposition film in the same manner as in Example 1, and the resultant was dried to produce a gas barrier laminate having a laminated structure of the barrier layer/the inorganic material layer/the base material.

### Comparative Example 1

A coating agent was produced in the same manner as in Example 1 except that the high-pressure dispersion process was not carried out. The obtained coating agent was applied onto the aluminum oxide vapor deposition film in the same manner as in Example 1, and the resultant was dried to produce a gas barrier laminate having a laminated structure of the barrier layer/the inorganic material layer/the base material.

### Evaluation of gas barrier laminate

### (1) Frictional force

The frictional forces were measured on straight lines of 1 µm at five places randomly selected on a surface of the obtained gas barrier laminate by atomic force microscopy (SPM-9700 manufactured by Shimadzu Corporation). A cantilever (manufactured by NanoWorld) having a spring constant of 0.2 N/m, a resonance frequency of 13 kHz, a rear AL coating and a tip radius of curvature of 8 nm (representative value) was used. The obtained frictional force profile was analyzed to calculate the frictional forces at five places of the barrier layer. Among the frictional forces at five places, the average value was calculated from the frictional forces at three places from which the maximum value and the minimum value were deleted. The obtained value was adopted as a frictional force of the barrier layer. The results are shown in Table 1 below.

### (2) Water vapor transmission rate

The water vapor transmission rate of the obtained gas barrier laminate was measured under conditions of a temperature of 40°C and a relative humidity of 90% RH using a water vapor transmission rate measurement instrument ("PERMATRAN-W 3/33" manufactured by MOCON, Inc.) in accordance with JIS K7129: 2008 B. The results are shown Table 1 below.

**[Table 1]**

| | High-pressure dispersion process | Frictional force (V) | Water vapor transmission rate (g/(m²·day)) |
|---|---|---|---|
| Example 1 | once | 2.6 × 10⁻⁴ | 1.5 |
| Example 2 | twice | 1.4 × 10⁻⁴ | 1.1 |
| Comparative Example 1 | - | 4.7 × 10⁻⁴ | 2.9 |

As shown in Table 1, the gas barrier laminates in Examples 1 and 2 where the frictional force of the barrier layer measured by atomic force microscopy was 3.0 × 10⁻⁴ (V) or less had a lower water vapor transmission rate and were more excellent in gas barrier properties, compared to the gas barrier laminate in Comparative Example 1 where the requirements for the frictional force were not satisfied.

### Industrial Applicability

The gas barrier laminate of the present invention is excellent in gas barrier properties and is useful, for example, for a packaging material for foods, medicines, and the like.

## Claims

1. A gas barrier laminate having a laminated structure comprising a barrier layer, an inorganic material layer and a base material in this order, wherein
the barrier layer includes a water-soluble resin and a condensate of hydrolyzed metal alkoxide, and
a frictional force of the barrier layer measured by atomic force microscopy is 3.0 × 10⁻⁴ (V) or less.

2. The laminate according to claim 1, wherein a content of the water-soluble resin in the barrier layer is from 10 to 90% by weight based on the entire barrier layer.

3. The laminate according to claim 1 or 2, wherein a solid content of metal oxide in the barrier layer, which is converted from an amount of metal alkoxide, is from 10 to 400 parts by weight based on 100 parts by weight of the content of the water-soluble resin.

4. The laminate according to any one of claims 1 to 3, wherein the water-soluble resin is polyvinyl alcohol.

5. The laminate according to any one of claims 1 to 4, wherein the condensate of hydrolyzed metal alkoxide is a condensate of hydrolyzed tetraethoxysilane and/or a condensate of hydrolyzed triisopropoxy aluminum.

6. The laminate according to any one of claims 1 to 5, wherein a thickness of the barrier layer is from 0.01 to 5.0 µm.

## Patentansprüche

1. Gasbarrierelaminat mit einer laminierten Struktur, umfassend eine Barriereschicht, eine Schicht aus einem anorganischen Material und ein Grundmaterial in dieser Reihenfolge, wobei
die Barriereschicht ein wasserlösliches Harz und ein Kondensat von hydrolysiertem Metallalkoxid einschließt, und
eine durch Atomkraftmikroskopie gemessene Reibungskraft der Barriereschicht 3,0 × 10⁻⁴ (V) oder weniger beträgt.

2. Laminat nach Anspruch 1, wobei ein Gehalt des wasserlöslichen Harzes in der Barriereschicht 10 bis 90 Gew.-% bezogen auf die gesamte Barriereschicht beträgt.

3. Laminat nach Anspruch 1 oder 2, wobei ein Feststoffgehalt von Metalloxid in der Barriereschicht, das aus einer Menge von Metallalkoxid umgewandelt wird, 10 bis 400 Gewichtsteile, bezogen auf 100 Gewichtsteile des Gehalts des wasserlöslichen Harzes, beträgt.

4. Laminat nach einem der Ansprüche 1 bis 3, wobei das wasserlösliche Harz Polyvinylalkohol ist.

5. Laminat nach einem der Ansprüche 1 bis 4, wobei das Kondensat von hydrolysiertem Metallalkoxid ein Kondensat von hydrolysiertem Tetraethoxysilan und/oder ein Kondensat von hydrolysiertem Triisopropoxyaluminium ist.

6. Laminat nach einem der Ansprüche 1 bis 5, wobei eine Dicke der Barriereschicht 0,01 bis 5,0 µm beträgt.

## Revendications

1. Stratifié formant barrière aux gaz ayant une structure stratifiée comprenant une couche barrière, une couche de matériau inorganique et un matériau de base dans cet ordre, dans lequel
la couche barrière inclut une résine soluble dans l'eau et un condensat d'alcoxyde métallique hydrolysé, et
une force de frottement de la couche barrière mesurée par microscopie à force atomique est inférieure ou égale à 3,0 × 10⁻⁴ (V).

2. Stratifié selon la revendication 1, dans lequel une teneur en résine hydrosoluble dans la couche barrière est comprise entre 10 et 90 % en poids par rapport à la totalité de la couche barrière.

3. Stratifié selon la revendication 1 ou la revendication 2, dans lequel une teneur solide en oxyde métallique dans la couche barrière, qui est convertie à partir d'une quantité d'alcoxyde métallique, est comprise entre 10 et 400 parties en poids sur la base de 100 parties en poids de la teneur en résine soluble dans l'eau.

4. Stratifié selon l'une quelconque des revendications 1 à 3, dans lequel la résine soluble dans l'eau est de l'alcool polyvinylique.

5. Stratifié selon l'une quelconque des revendications 1 à 4, dans lequel le condensat d'alcoxyde métallique hydrolysé est un condensat de tétraéthoxysilane hydrolysé et/ou un condensat de triisopropoxyaluminium hydrolysé.

6. Stratifié selon l'une quelconque des revendications 1 à 5, dans lequel une épaisseur de la couche barrière est comprise entre 0,01 et 5,0 µm.
